# FASCICULE DE BREVET EUROPEEN

(11) **EP 2 406 409 B1**
(45) Date de publication et mention de la délivrance du brevet: **10.10.2018**
(21) Numéro de dépôt: 10707925.3
(22) Date de dépôt: 12.03.2010
(51) Int. Cl.: C23C 14/35, C23C 14/34, C23C 28/02, C23C 14/00

(54) **DECORATION PAR PULVERISATION PLASMA MAGNETRON SUR DES CONTENANTS EN VERRE POUR LES SECTEURS DE LA COSMETIQUE**
DEKORATION DURCH MAGNETRONPLASMASPUTTERN AUF GLASBEHÄLTER FÜR DIE KOSMETIKSEKTOREN
DECORATION BY MAGNETRON PLASMA SPUTTERING ONTO GLASS CONTAINERS FOR THE COSMETIC SECTORS

(30) Priorité: 12.03.2009 FR 0951558
(43) Date de publication de la demande: 18.01.2012
(73) Titulaire: Centre National de la Recherche Scientifique (C.N.R.S.), 75016 Paris (FR); Universite d'Orleans, 45000 Orléans (FR); DB Technique, 45160 Olivet (FR)
(72) Inventeur: BRAULT, Pascal, F-45560 Saint Denis En Val (FR); DOLIQUE, Vincent, F-37000 Tours (FR); BOURIN, Dominique, F-45160 Olivet (FR)
(74) Mandataire: Lavoix
(86) Numéro de dépôt international: PCT/EP2010/053170
(87) Numéro de publication internationale: WO 2010/103097

(56) Documents cités:
- EP-A- 0 140 032
- EP-A2- 1 608 211
- WO-A-01/09051
- WO-A-02/20282
- WO-A-97/01775
- FR-A- 2 905 707
- JP-A- S 575 870
- US-A- 4 917 963
- US-A1- 2004 173 305
- US-A1- 2004 216 992

## Description

L'invention concerne le domaine de l'application de décorations sur des contenants destinés au marché du luxe et de la beauté.

En effet, il s'agit de décorer et parachever des contenants verres ou plastiques destinés au marché cosmétique.

L'industrie cosmétique fait appel en matière d'outsourcing, aux procédés les plus novateurs, tant sur le plan technique qu'esthétique.

L'objectif visé étant d'être le premier à commercialiser en "exclusivité" la nouveauté du moment, qui demain pourrait devenir un "institutionnel" de la marque.

Les différents procédés utilisés actuellement pour décorer les contenants alcooliques reposent sur l'apport de signatures adhésives "facing" à l'emblème de la marque, la métallisation sous vide, la sérigraphie directe sur verre, la tampographie, la sublimation ou le sleeve thermo rétreint.

Dans certains cas, l'ensemble est parachevé par un laquage de vernis incolore.

En matière de métallisation, la seule couleur représentée au travers des produits commercialisés à ce jour, est le chrome brillant.

Il existe donc un besoin en d'autres finitions avec de nouvelles couleurs, voire des variations et décors multi- couleurs, tout particulièrement pour la décoration des contenants alcooliques.

Les inventeurs ont montré qu'il est possible de déposer un film métallique d'inox, de cuivre, d'argent ou d'or uniforme et homogène par pulvérisation plasma magnétron sur du verre, en particulier sur un flacon en verre, qu'il soit plan ou en volume. Ils ont en particulier montré que la technique mise en oeuvre permet de conjuguer un excellent rendu métallique de la couche appliquée, une profondeur optique de grande qualité associée à une brillance et un tendu remarquable.

Dans certaines conditions, il a été obtenu une finition métallique laissant deviner le contenu du flacon (à l'image de la glace sans teint).

Les technologies plasma sont couramment employées pour le dépôt de films métalliques minces et parmi celles-ci la pulvérisation magnétron est largement utilisée.

La pulvérisation cathodique est une technique qui permet la synthèse de plusieurs matériaux à partir de la condensation d'une vapeur métallique issue d'une source solide, dite la cible, sur un substrat.

Les documents US4917963 et JPS575870 divulguent des couches minces de cuivre. L'application d'une différence de potentiel entre la cible et les parois du réacteur au sein d'une atmosphère raréfiée permet la création d'un plasma froid, composé d'électrons, d'ions, de photons et de neutres dans un état fondamental ou excité. Sous l'effet du champ électrique, les espèces positives du plasma se trouvent attirées par la cathode (cible) et entrent en collision avec cette dernière. Elles communiquent alors leur quantité de mouvement, provoquant ainsi la pulvérisation des atomes sous forme de particules neutres qui se condensent sur le substrat. La formation du film s'effectue selon plusieurs mécanismes qui dépendent des forces d'interactions entre le substrat et le film.

La décharge est auto-entretenue par les électrons secondaires émis de la cible. En effet, ceux-ci, lors de collisions inélastiques, transfèrent une partie de leur énergie cinétique en énergie potentielle aux atomes d'argon qui peuvent s'ioniser.

Afin d'augmenter la densité ionique au voisinage de la cible, celle-ci est équipée d'un dispositif magnétron, qui est constitué de deux aimants permanents de polarité inverse situés sous la cible. Ils créent un champ magnétique parallèle à la surface de la cible et orthogonal au champ électrique. La combinaison de ces deux champs donne naissance à des lignes de champ qui piègent les électrons secondaires. La force de Lorentz induite provoque un mouvement hélicoïdal des électrons augmentant ainsi leur trajectoire et, de ce fait, leur efficacité d'ionisation.

La pulvérisation plasma magnétron vise le domaine de l'électronique, en particulier des semi-conducteurs. Cependant, les substrats de ce domaine sont très différents du verre et du plastique et ils présentent une surface plane.

Le problème technique résolu par la présente invention consiste donc à appliquer une ou plusieurs couches métalliques par pulvérisation plasma magnétron sur un substrat, en particulier un substrat en verre ou en plastique de forme complexe.

La présente invention a ainsi pour objet un procédé de dépôt d'une ou plusieurs couches minces d'un ou plusieurs métaux sur un substrat, selon revendication 1, comprenant :
(i) une étape de pulvérisation plasma magnétron à partir d'une cible afin d'appliquer une ou plusieurs couches d'un métal qui adhère directement au substrat,
(ii) une étape subséquente de co-dépôt à partir d'une cible dudit métal qui adhère directement au substrat et d'une cible d'un métal qui présente une faible adhésion au substrat, ce co-dépôt résultant en un gradient entre le métal qui adhère directement au substrat et le métal présentant une faible adhésion au substrat, et
(iii)une étape subséquente de pulvérisation plasma magnétron sur la ou les couches obtenues à l'étape précédente à partir d'une cible dudit métal présentant une faible adhésion au substrat.

Préférentiellement, le substrat est le verre ou le plastique.

Selon l'invention, le métal qui adhère directement au substrat est un alliage, de préférence l'inox, le laiton ou le bronze.

Selon l'invention, une couche d'inox est déposée sur le substrat, puis un gradient d'inox et d'un métal qui présente une faible adhésion au substrat est déposé sur la couche d'inox. Enfin, la couche du métal qui présente une faible adhésion au substrat est déposée sur le gradient.

Selon l'invention le métal qui présente une faible adhésion au substrat est l'or, le cuivre ou l'argent.

L'étape (ii) peut être réalisée en diminuant progressivement la puissance de la cible formant la ou les couches de métal qui adhère directement au substrat tout en augmentant au même rythme ou en maintenant constante la puissance de la cible formant la ou les couches de métal qui présente une faible adhésion au substrat.

Les avantages du procédé selon l'invention sont qu'il est simple car il intègre toutes les étapes de réalisation et propre car exempt de tous produits chimiques.

On entend par « couche mince » une couche de quelques nanomètres à plusieurs milliers de nanomètres.

De préférence, plusieurs couches minces sont déposées.

On entend par « cible métallique » une cible d'un métal pur ou d'un alliage.

Parmi les métaux on peut citer, le cuivre, l'argent, le tungstène, l'or, le platine.

Parmi les alliages on peut citer l'inox, le laiton, le bronze.

Une ou plusieurs, de préférence, deux cibles métalliques sont présentes dans le réacteur.

En cas de pluralité de cibles, celles-ci peuvent être utilisées alternativement ou simultanément.

Le verre peut être de tout type, transparent, translucide ou opaque, lisse ou dépoli. Le plastique peut être de tout type, transparent, translucide ou opaque. Le plastique peut être du polyéthylène, du polytétrafluoroéthylène, du polyéthylène térephtalate, du nylon, du polyvinylchlorure, du polypropylène, du polyester, du polycarbonate, du polyméthylmétacrylate.

De préférence, le substrat traité par le procédé de l'invention est un substrat complexe. On entend par « substrat complexe » un substrat présentant une surface à traiter non plane. En particulier, on entend par surface non plane une surface présentant des formes convexes et/ou concaves.

Le substrat, en particulier le substrat complexe, est fixé sur un support mobile en rotation et en translation par rapport au réacteur afin de favoriser un dépôt homogène.

Selon un mode de réalisation de l'invention, le ou les étapes de pulvérisation plasma magnétron à partir d'une ou plusieurs cibles métalliques est/sont précédée(s) d'une étape préalable de prétraitement du substrat par plasma radiofréquence, micro-ondes ou basses fréquences.

Ce pré-traitement est particulièrement avantageux pour améliorer l'adhésion de la ou des couches métalliques.

De préférence, le pré-traitement est réalisé par plasma radiofréquence. La radiofréquence est alors émise par une antenne radiofréquence présente à l'intérieur du réacteur ou à l'extérieur du réacteur près d'un hublot donnant sur l'intérieur du réacteur pour créer un plasma proche du substrat.

Selon un mode de réalisation additionnel, le dépôt est réalisé en pleine surface ou le dépôt est « zoné ».

Par dépôt « zoné » on entend un dépôt recouvrant partiellement le substrat.

De préférence, un dépôt « zoné » permet de réaliser une forme, un motif ou un logotype pour décorer le substrat.

Le premier protocole consiste à déposer une couche de protection (encre polymère) soluble dans l'eau, l'alcool ou un solvant compatible avec le dépôt.

Le second protocole consiste à utiliser un masque "custom", une housse polymère ou métallique, en contact ou non avec le contenant à métalliser.

Le gaz plasmagène peut être choisi dans le groupe constitué de l'argon, hélium, néon, argon, krypton, xénon.

De préférence, le gaz plasmagène est l'argon.

La pression du gaz plasmagène est comprise entre 0,1.10⁻³ et 500.10⁻³ mbar, de préférence entre 1.10⁻³ et 100.10⁻³ mbar, de manière particulièrement préférée entre 3.10⁻³ et 50.10⁻³ mbar.

La puissance sur les cibles est comprise entre 0,1 et 100 W.cm⁻², de préférence entre 0,1 et 20 W.cm⁻², de manière particulièrement préférée entre 1 et 10 W.cm⁻².

De l'oxygène peut être ajouté au gaz plasmagène afin de réaliser le dépôt d'un oxyde du métal de la cible. Par exemple, l'ajout d'oxygène au gaz plasmagène permet de déposer de l'oxyde d'or à partir d'une cible d'or pour obtenir un dépôt plus adhérent.

Le procédé selon l'invention peut comprendre une étape finale de dépôt d'une ou plusieurs couches de protection des couches métalliques.

Les couches de protection peuvent consister en des couches de polymère, par exemple polyuréthane, PET, de vernis, de SiOx et/ou d'un métal qui adhère directement au substrat, préférentiellement un alliage tel que l'inox, le laiton ou le bronze. De préférence, les couches de protection sont transparentes. Les vernis peuvent être déposés par pistolage ou spray. Le dépôt de polymère, de SiOx et/ou de métal qui adhère directement au substrat peut être réalisé par spray ou par pulvérisation plasma magnétron RF ou DC puisée.

Les différents modes de réalisation décrits ci-dessus du procédé de l'invention peuvent être combinés.

Un procédé préféré de l'invention consiste en une combinaison préférée des différents modes de réalisation du procédé de l'invention suivante :
a) pré-traitement du substrat par plasma radio-fréquences,
b) puis dépôt de plusieurs couches d'un métal adhérant directement au substrat par pulvérisation plasma magnétron,
c) puis dépôt d'un gradient entre le métal adhérant directement au substrat et un métal pur qui n'adhère pas directement au substrat par pulvérisation plasma magnétron,,
d) puis dépôt d'une ou plusieurs couches d'un métal pur qui n'adhère pas directement au substrat par pulvérisation plasma magnétron,,
e) puis dépôt d'une couche de protection.

Un autre objet de l'invention concerne un substrat en verre ou en plastique susceptible d'être obtenu selon le procédé de l'invention.

De préférence, le substrat de l'invention est un contenant adapté pour contenir un produit cosmétique, de préférence encore un flacon, un pot, un poudrier ou une bouteille.

On entend par produit cosmétique un produit de soin cosmétique, un parfum ou un produit de maquillage.

Les exemples suivants illustrent l'invention sans en limiter la portée.

### Exemple 1 : Prétraitement par plasma radiofréquence (RF)

On réalise le pré-traitement d'un flacon en verre par plasma RF en plaçant une antenne radiofréquences 13,56 MHz dans le réacteur.

Le gaz plasmagène est l'argon.

Dans les exemples suivants, les conditions de prétraitement sont :
f) Puissance radiofréquence 80 W,
g) durée de traitement 5 minutes et
h) pression d'argon : 3.10⁻³ mbar.

Les Exemples 2 à 8 sont réalisés avec un pré-traitement selon l'Exemple 1. Ils ont lieu à température ambiante avec une rotation des flacons de 2 tours/min.

Pour obtenir un dépôt homogène en épaisseur, une translation du flacon devant le magnétron est réalisée durant le dépôt.

### Exemple 2 : Dépôt d'inox sur flacon de verre

Une cible d'Inox est pulvérisée dans une enceinte de dépôt magnétron. Les couches sont adhérentes sans ajouter d'autres éléments stabilisants.

Des essais à haute pression (1 10⁻² mbar) permettent une bonne tenue de la couche mince sur le flacon (test scotch). Une variation de la puissance n'altère pas la tenue de la couche mince sur le flacon.

Plusieurs essais sur les différents flacons (qui ne possèdent pas la même formulation chimique) montrent une bonne adhérence de la couche d'inox.

Un dépôt d'une couche mince sur le flacon sérigraphié permet (après un bain dans l'eau chaude) d'obtenir un « zonage » de la couche mince. Pour éviter réchauffement du flacon et de la sérigraphie durant le dépôt, l'alimentation est puisée : Le magnétron est alimenté pendant 30 secondes puis arrêté les 30 secondes suivantes. Ce cycle est répété pour obtenir le temps de dépôt souhaité.

Bilan des tests sur les couches minces d'inox adhérentes au scotch :
- Bain d'eau industrielle durant 48h : pas d'altération de la couche.
- Bain d'acide (Potassium Hydrogen Phthalate C₈H₅O₄K, pH = 4) durant 24h : pas d'altération de la couche.
- Nettoyage avec Acétone et Alcool : pas d'altération de la couche.

### Exemple 3 : Dépôt de cuivre sur flacon de verre avec sous-couche inox

Un co-dépôt Inox-Cuivre avec un gradient permettant d'obtenir la teinte du Cuivre en surface a été réalisé. Pour cela, les deux cibles de cuivre et d'Inox sont présentes dans le réacteur. Un premier dépôt d'Inox est réalisé avec les conditions permettant une bonne adhésion puis la puissance sur la cible de cuivre est progressivement augmentée tandis que la puissance sur la cible d'Inox est réduite progressivement jusqu'à 0 sur une durée définie. On dépose alors uniquement du cuivre pendant quelques minutes, cela permet d'obtenir une teinte cuivrée et d'avoir une bonne adhésion du film sur le flacon.

Un exemple précis de réalisation se fait comme suit :
Gaz plasmagène Argon. Débit 25 sccm, Pression 10⁻² mbar
1) Dépôt Inox durant 14 min,
   Puis
2) Gradient de composition Inox et Cuivre comme suit (3 minutes)
   - cible Inox baisse de la puissance de 20W toutes les 30 secondes jusqu'à 70W puis arrêt.
   - simultanément cible Cu : hausse de la puissance de 20W toutes les 30 secondes à partir de 70 W jusqu'à 150W
3) Dépôt de Cu, 150 W durant 6 minutes.

### Exemple 4 : Dépôt d'or sur flacon de verre avec sous-couche inox

Des essais montrent que le dépôt d'or seul sur le flacon ne permet pas d'obtenir une bonne adhérence du film.

En revanche, la procédure définie à l'Exemple 3 avec le cuivre permet d'obtenir une bonne adhésion avec l'or.

Une réalisation peut donc être :
Gaz plasmagène Ar. Débit 25 sccm, Pression 10⁻² mbar
1) Dépôt Inox durant 14 min,
   Puis
2) Gradient de composition Inox et Or comme suit (3 minutes)
   - cible Inox baisse de la puissance de 20W toutes les 30 secondes jusqu'à 70W puis arrêt.
   - simultanément cible Or : hausse de la puissance de 20W toutes les 30 secondes à partir de 70 W jusqu'à 150W
   Puis
3) Dépôt d'Or, 150 W durant 6 minutes.

### Exemple 5 : Dépôt de cuivre sur flacon de verre avec sous-couche inox

Un co-dépôt Inox-Cuivre avec un gradient permettant d'obtenir la teinte du Cuivre en surface a été réalisé. Pour cela, les deux cibles de cuivre et d'Inox sont présentes dans le réacteur. Un premier dépôt d'Inox est réalisé avec les conditions permettant une bonne adhésion puis la puissance sur la cible de cuivre est progressivement augmentée tandis que la puissance sur la cible d'Inox est réduite progressivement jusqu'à une puissance définie sur une durée définie. On dépose alors uniquement du cuivre pendant quelques minutes, cela permet d'obtenir une teinte cuivrée et d'avoir une bonne adhésion du film sur le flacon.

Un exemple de réalisation se fait comme suit :
Gaz plasmagène Argon. Débit 25 sccm, Pression 10⁻² mbar
1) Dépôt Inox durant 4 min, 300W
   Puis
2) Gradient de composition Inox et Cuivre comme suit
   - cible Inox : baisse de la puissance de 40W toutes les 30 secondes jusqu'à 120W puis
      arrêt.
   - simultanément cible Cu : hausse de la puissance de 20W toutes les 30 secondes à
      partir de 70 W jusqu'à 150W
3)
   a) Nous pouvons alors arrêter la cible de Cuivre en même temps que la cible d'Inox. Nous obtenons alors une autre teinte. Nous n'avons pas de métal pur à la surface du flacon.
   b) ou nous pouvons réaliser un dépôt de Cu, 150W durant 3 min pour obtenir une teinte proche du métal pur (Cu).

### Exemple 6 : Dépôt d'or ou d'argent sur flacon de verre avec sous-couche inox

L'exemple 5 est réalisé à l'identique en remplaçant la cible de cuivre par une cible d'argent ou d'or.

### Exemple 7 :

Nous pouvons réaliser les couches minces citées dans les exemples 1 à 6 et réaliser un dépôt très court d'Inox. Cette fine couche d'Inox présente deux avantages :
a) elle est transparente ou modifie la teinte finale du flacon.
b) elle protège la couche mince.

### Exemple 8 (Exemple comparatif) : Dépôt de cuivre, d'or ou d'argent sur flacon de verre sans sous-couche inox

Si on réalise l'exemple 6 ou l'exemple 7 sans sous-couche d'inox, le dépôt de cuivre, d'or ou d'argent n'adhère pas au flacon.

## Revendications

1. Procédé de dépôt par pulvérisation plasma magnétron de plusieurs couches minces de plusieurs métaux sur un substrat, comprenant :
(i) une étape de pulvérisation plasma magnétron à partir d'une cible afin d'appliquer une ou plusieurs couches d'un métal qui adhère directement au substrat, ledit métal étant choisi parmi l'inox, le laiton ou le bronze,
(ii) une étape subséquente de co-dépôt à partir d'une cible dudit métal qui adhère directement au substrat et d'une cible d'un métal pur qui présente une faible adhésion au substrat, ledit métal étant choisi parmi l'or, l'argent, le cuivre, le platine ou le tungstène, ce co-dépôt résultant en un gradient entre le métal qui adhère directement au substrat et le métal présentant une faible adhésion au substrat, et
(iii)une étape subséquente de pulvérisation plasma magnétron sur la ou les couches obtenues à l'étape précédente à partir d'une cible dudit métal présentant une faible adhésion au substrat.

2. Procédé selon la revendication 1, **caractérisé en ce que** le substrat est en verre ou en plastique.

3. Procédé selon la revendication 1 ou 2, **caractérisé en ce que** le substrat présente une surface à traiter non plane.

4. Procédé selon la revendication 3, **caractérisé en ce que** le substrat présente une surface présentant des formes convexes ou concaves.

5. Procédé selon l'une quelconque des revendications précédentes,, comprenant une étape de prétraitement du substrat par plasma radiofréquence, micro-ondes ou basses fréquences préalablement au dépôt de la ou des couches de métaux.

6. Procédé selon l'une quelconque des revendications précédentes, comprenant :
(i) une première étape de pulvérisation plasma magnétron à partir d'une cible d'inox,
(ii) une deuxième étape subséquente de pulvérisation plasma magnétron à partir de deux cibles simultanément, l'une d'inox et l'autre d'or, de cuivre ou d'argent sur la ou les couches d'inox obtenue(s) à l'étape précédente, résultant en un gradient entre l'inox et, respectivement l'or, le cuivre ou l'argent, et
(iii)une troisième étape subséquente de pulvérisation plasma magnétron à partir d'une cible, respectivement d'or, de cuivre ou d'argent, sur les couches obtenues à l'étape précédente.

7. Procédé selon l'une quelconque des revendications précédentes, le gaz plasmagène étant l'argon.

8. Procédé selon l'une quelconque des revendications précédentes, de l'oxygène étant ajouté au gaz plasmagène.

9. Procédé selon l'une quelconque des revendications précédentes, comprenant une étape finale de dépôt d'une ou plusieurs couches de protection des couches métalliques.

10. Procédé selon la revendication 11, comprenant une étape finale de dépôt d'une ou plusieurs couches de protection des couches métalliques consistant en des couches de polymère, de vernis, de SiOₓ et/ou d'alliage.

11. Substrat en verre ou en plastique susceptible d'être obtenu selon le procédé selon l'une quelconque des revendications précédentes.

12. Substrat selon la revendication 11, **caractérisé en ce qu'**il s'agit d'un contenant adapté pour contenir un produit cosmétique.

13. Substrat selon la revendication 11 ou 12, **caractérisé en ce qu'**il s'agit d'un flacon, d'un pot, d'un poudrier ou d'une bouteille.

## Patentansprüche

1. Verfahren zur Ablagerung durch Magnetronplasmasputtern von mehreren dünnen Schichten aus mehreren Metallen auf einem Substrat, umfassend:
(i) einen Schritt des Magnetronplasmasputterns ausgehend von einem Ziel, um eine oder mehrere Schichten eines Metalls anzuwenden, das direkt auf dem Substrat haftet, wobei das Metall ausgewählt ist aus Edelstahl, Messing oder Bronze,
(ii) einen folgenden Schritt des gemeinsamen Ablagerns, ausgehend von einem Ziel des Metalls, das direkt auf dem Substrat haftet, und eines Ziels eines reinen Metalls, das eine schwache Haftung am Substrat aufweist, wobei das Metall ausgewählt ist aus Gold, Silber, Kupfer, Platin oder Wolfram, wobei diese gemeinsame Ablagerung zu einem Gradienten zwischen dem Metall, das direkt auf dem Substrat haftet, und dem Metall, das einen schwache Haftung auf dem Substrat aufweist, führt, und
(iii) einen folgenden Schritt des Magnetronplasmasputterns auf der oder den Schichten, erhalten im vorhergehenden Schritt, ausgehend von einem Ziel des Metalls, das eine schwache Haftung auf dem Substrat aufweist.

2. Verfahren nach Anspruch 1, **dadurch gekennzeichnet, dass** das Substrat aus Glas oder Plastik ist.

3. Verfahren nach Anspruch 1 oder 2, **dadurch gekennzeichnet, dass** das Substrat eine nicht ebene zu behandelnde Oberfläche aufweist.

4. Verfahren nach Anspruch 3, **dadurch gekennzeichnet, dass** das Substrat eine Oberfläche aufweist, die konvexe oder konkave Formen aufweist.

5. Verfahren nach einem beliebigen der vorhergehenden Ansprüche, umfassend einen Schritt des Vorbehandelns des Substrats durch Radiofrequenzplasma, Mikrowellen oder niedrige Frequenzen vor der Ablagerung der Metallschicht oder der Metallschichten.

6. Verfahren nach einem beliebigen der vorhergehenden Ansprüche, umfassend:
(i) einen ersten Schritt des Magnetronplasmasputterns ausgehend von einem Edelstahlziel,
(ii) einen zweiten folgenden Schritt des Magnetronplasmasputterns ausgehend von gleichzeitig zwei Zielen, einem aus Edelstahl und dem anderen aus Gold, Kupfer oder Silber, auf der oder den Schichten aus Edelstahl, erhalten im vorhergehenden Schritt, der zu einem Gradienten zwischen Edelstahl und jeweils Gold, Kupfer oder Silber führt, und
(iii) einen dritten folgenden Schritt des Magnetronplasmasputterns ausgehend von einem Ziel, jeweils aus Gold, Kupfer oder Silber, auf den Schichten, erhalten im vorhergehenden Schritt.

7. Verfahren nach einem beliebigen der vorhergehenden Ansprüche, wobei das Plasmagas Argon ist.

8. Verfahren nach einem beliebigen der vorhergehenden Ansprüche, wobei dem Plasmagas Sauerstoff zugegeben wird.

9. Verfahren nach einem beliebigen der vorhergehenden Ansprüche, umfassend einen Endschritt des Ablagerns von einer oder von mehreren Schutzschichten der Metallschichten.

10. Verfahren nach Anspruch 11, umfassend einen Endschritt des Ablagerns von einer oder von mehreren Schutzschichten der Metallschichten, bestehend aus Polymer-, Lack-, SiOₓ und/oder Legierungsschichten.

11. Substrat aus Glas oder aus Plastik, das nach dem Verfahren nach einem beliebigen der vorhergehenden Ansprüche erhalten werden kann.

12. Substrat nach Anspruch 11, **dadurch gekennzeichnet, dass** es sich um ein Behältnis handelt, das ausgelegt ist, um ein kosmetisches Produkt zu enthalten.

13. Verfahren nach Anspruch 11 oder 12, **dadurch gekennzeichnet, dass** es sich um ein Fläschchen, einen Topf, eine Puderdose oder eine Flasche handelt.

## Claims

1. Method of magnetron plasma sputtering deposition of multiple thin layers of a plurality of metals on a substrate, comprising:
(i) a step of magnetron plasma sputtering from a target in order to apply one or more layers of a metal which adheres directly to the substrate, wherein the metal is selected from stainless steel, brass or bronze,
(ii) a subsequent step of co-deposition from a target of the metal which adheres directly to the substrate and from a target of a pure metal which has low adhesion to the substrate, wherein the metal is selected from gold, silver, copper, platinum or tungsten, wherein this co-deposition results in a gradient between the metal which adheres directly to the substrate and the metal which has low adhesion to the substrate, and
(iii) a subsequent step of magnetron plasma sputtering on the layer(s) obtained in the preceding step from a target of the metal having low adhesion to the substrate.

2. Method according to claim 1, **characterized in that** the substrate is made of glass or plastic.

3. Method according to claim 1 or 2, **characterized in that** the substrate has a non-planar surface to be treated.

4. Method according to claim 3, **characterized in that** the substrate has a surface having convex or concave shapes.

5. Method according to any one of the preceding claims, comprising a step of pretreatment of the substrate by radiofrequency, microwave or low frequency plasma prior to the deposition of the layer(s) of metals.

6. Method according to any one of the preceding claims, comprising:
(i) a first step of magnetron plasma sputtering from a stainless steel target,
(ii) a second subsequent step of magnetron plasma sputtering simultaneously from two targets, wherein one is of stainless steel while the other is of gold, copper or silver on the stainless steel layer(s) obtained in the preceding step, resulting in a gradient between the stainless steel and, respectively, the gold, copper or silver, and
(iii) a third subsequent step of magnetron plasma sputtering from a target, respectively of gold, copper or silver, on the layers obtained in the previous step.

7. Method according to any one of the preceding claims, wherein the plasmagenic gas is argon.

8. Method according to any one of the preceding claims, wherein oxygen is added to the plasmagenic gas.

9. Method according to any one of the preceding claims, comprising a final step of depositing one or more protective layers on the metal layers.

10. Method according to claim 11, comprising a final step of depositing one or more protective layers on the metal layers consisting of polymer, varnish, SiOx and/or alloy layers.

11. Glass or plastic substrate obtainable by the method according to any one of the preceding claims.

12. Substrate according to claim 11, **characterized in that** it is a container adapted to contain a cosmetic product.

13. Substrate according to claim 11 or 12, **characterized in that** it is a vial, a pot, a compact or a bottle.
